# EUROPEAN PATENT SPECIFICATION

(11) **EP 1 038 260 B1**
(45) Date of publication and mention of the grant of the patent: **04.06.2003**
(21) Application number: 98961330.2
(22) Date of filing: 18.12.1998
(51) Int. Cl.: G06K 9/64, G06F 15/80

(54) **NEURAL NETWORKS**
NEURONALE NETZWERKE
RESEAUX NEURONAUX

(30) Priority: 19.12.1997 GB 9726752; 27.10.1998 GB 9823361
(43) Date of publication of application: 27.09.2000
(73) Proprietor: BAE SYSTEMS plc, Farnborough, Hampshire GU14 6YU (GB)
(72) Inventor: KING, Douglas, B. S., British Aerospace, Near Preston, Lancashire PR4 1AX (GB)
(74) Representative: Newell, William Joseph
(86) International application number: PCT/GB98/03832
(87) International publication number: WO 99/033019

(56) References cited:
- EP-A- 0 694 855
- US-A- 5 487 133
- US-A- 5 630 021
- VAN DE PANNE M ET AL: "MACHAM: A BEST MATCH CONTENT ADDRESSABLE MEMORY" PROCEEDINGS OF THE PACIFIC RIM CONFERENCE ON COMMUNICATIONS, COMPUTERS AND SIGNAL PROCESSING, VICTORIA, JUNE 1 - 2, 1989, 1 June 1989, pages 612-615, XP000077554 INSTITUTE OF ELECTRICAL AND ELECTRONICS ENGINEERS
- CHENG-AN HUNG ET AL: "A match-based clustering neural network for stable category learning of multiple-valued patterns" JOURNAL OF INFORMATION SCIENCE AND ENGINEERING, DEC. 1997, INST. INF. SCI., ACAD. SINICA, TAIWAN, vol. 13, no. 4, pages 543-562, XP002101325 ISSN 1016-2364

## Description

This invention relates to neural networks incorporating sum and threshold devices and in particular, but not exclusively to such networks capable of functioning as a neural pattern matcher. The invention also extends to sum and threshold devices for receiving weightless synaptic inputs and a weighted threshold value.

The apparatus and methods described herein may usefully incorporate, utilise, be used with or incorporated into any of the apparatus or methods described in our published Applications Nos. WO99/33184, WO99/32961, WO99/33175 or WO99/32962.

### Terminology

The term "Hamming value" is used to define the number of bits set in 1-dimensional arrays such as a binary number, tuple, vector or 2 or higher dimensional arrays, that is the number of 1's set. The Hamming value relationship of two binary numbers or arrays indicates which has the greater Hamming value or whether the Hamming values are the same.

The term "weighted binary" is used in the conventional sense to indicate that successive bit positions are weighted, particularly .... 16, 8, 4, 2, 1 although other weighted representations are possible. "Weightless binary" is a set of binary digits 1 and 0, each representing just "1" and "0" respectively. There is no least significant bit (LSB) or most significant bit (MSB). The set of bits may be ordered or without order. If all the 1's are grouped together e.g. [111000] then the code is referred to as a thermometer code, thermocode or bar graph code, all collectively referred to herein as "thermometer codes". Equally, the term thermometer code is used broadly to cover 1 or higher dimensional arrays in which the set bits have been aggregated around a pre-set focal bit, which may be anywhere in the array.

A set of weightless bits is referred to herein as a "weightless tuple" or "weightless vector" and these terms are not intended to be restricted to ordered sets.

In traditional neural networks, a real-valued synaptic value is multiplied by a synaptic connection strength or weight value, and summed with other similarly treated synapses before they are all summed and thresholded to form a neural output. The weight value is a real-valued synaptic connection strength and hence the common usage of the term "weighted neural network". However, it is also possible to have binary RAM-based neural networks that do not employ real-valued connection weights but instead rely on the values of the binary bits being either 0 or 1. Accordingly, there are two contexts of weightlessness: without synaptic connection strength, and without binary code weighting. The arrangements described herein employ weightless binary manipulation mechanisms and may be used to engineer weightless artificial neural networks, otherwise referred to as weightless-*weightless* artificial neural networks.

In one context, this invention is concerned with the comparison of two weightless vectors in terms of their Hamming values. This process is broadly equivalent to the function of a binary neuron. If the neuron receives a vector, A, of weightless synaptic values (e.g. [10110010]), and a vector, T, of weightless neural threshold values (e.g. [00101000]), the neuron may be required to fire because the Hamming value of A is greater than the Hamming value of T. In this example, the threshold, T, can be thought of as a set of inhibitory synaptic values which must be exceeded if the neuron is to be fired. The neural networks, devices, and techniques disclosed herein may be used in flight control systems, voting systems with redundancy, safety critical systems, telecommunications systems, decision making systems, and artificial intelligence systems, such as neural networks.

US-A-5487133 describes a classifier which calculates a distance between an input pattern and each prestored prototype.

US-A-5,630,021 describes a Hamming neural network circuit having N inputs and M exemplar template outputs.

According to one aspect, this invention provides a device for processing data representing a plurality of exemplars thereby to determine a generic template representing said exemplars, said device comprising:-
an array of bit memory means defining a neural memory for storing binary bits representing a plurality of exemplars, and
an array of sum and threshold devices each for receiving as inputs the bits from respective groups of said bit memory means in said array, and each for providing a preset output if the sum of said inputs exceeds a preset threshold, thereby to obtain at the output of said array of sum and threshold devices a bit pattern defining a generic template representing said exemplars.

The device as described above preferably is further operable to determine the effect of matching between a set of input data and said plurality of exemplars. In this instance the device preferably includes means for comparing or correlating a set of input data with said generic template at each of a plurality of bit positions, and providing an output representative of the extent of matching between said set of input data and said generic template.

Preferably, said neural memory comprises means for storing a plurality of 2-dimensional data arrays. The neural network preferably includes means for presenting said input data in parallel to a data plane for correlation with said generic template. The means for correlating preferably comprises an array of logic elements. In a preferred embodiment the network includes further sum and threshold means for comparing the sum of said correlation results with a threshold and for providing an output representative of a match, if said sum exceeds said threshold.

The sum and threshold devices may take many forms but the, or at least one of the sum and threshold devices preferably comprises a Hamming value comparator made up of a plurality of interconnected bit manipulation cells, each bit manipulation cell being operable to effect at least one of a bit shift and a bit elimination operation.

In yet another aspect, this invention provides a method for processing a set of input data and a plurality of exemplars to determine the extent of matching therebetween which comprises:
(i) providing an array of sum and threshold devices each with an input and an output and operable to provide a preset output if the sum of the bits applied to the input exceeds a preset threshold;
(ii) for each exemplar applying respective bits thereof to the inputs of respective sum and threshold devices according to the bit position,
thereby to obtain a bit pattern defining a generic template representing said exemplars, and comparing or correlating said set of input data with said generic template.

In a further aspect, this invention provides a method of processing a plurality of exemplars, thereby to determine a generic template representing said exemplars, which comprises:-
(i) providing an array of sum and threshold devices each with an input and an output and operable to provide a preset output if the sum of the bits applied to the input exceeds a preset threshold;
(ii) for each exemplar applying respective bits thereof to the inputs of respective sum and threshold devices according to the bit position,
thereby to obtain a bit pattern defining a generic template representing said exemplars.

The invention may be performed in various ways, and, by way of example only, various embodiments thereof will now be described in detail, reference being made to the accompanying drawings which utilise the conventional symbols for logic gates and in which:-
Figure 1 is a schematic diagram of a sum and threshold (SAT) device;
Figure 2 is a diagram of a neural network for processing data in accordance with this invention;
Figure 3 is a diagram of a sum and threshold element with weightless synaptic inputs and a weighted binary threshold;
Figure 4 is a diagram of a sum and threshold element of the type in Figure 3, employing a thermometer code converter; and
Figure 5 is a diagram of a bit manipulator cell used in the thermometer code converter of Figure 4.

The embodiments described herein make use of sum and threshold devices, which may take many forms. Examples of novel Hamming value comparators which may serve as sum and threshold devices are described in our copending International Patent Application No. WO99/32961. Alternatively, the sum and threshold detectors may take the form of a binary thermometer code converter of the type described in our co-pending International Patent Application No. WO 99/33184 with a suitable output selector, as to be described below. The Hamming Comparators and Binary Code Converters described in these documents have the advantage that they can be implemented asynchronously, and thus be robust, fault tolerant and highly immune to RFI/EMI effects. However, of course, conventional sum and threshold devices may also be used in carrying out this invention.

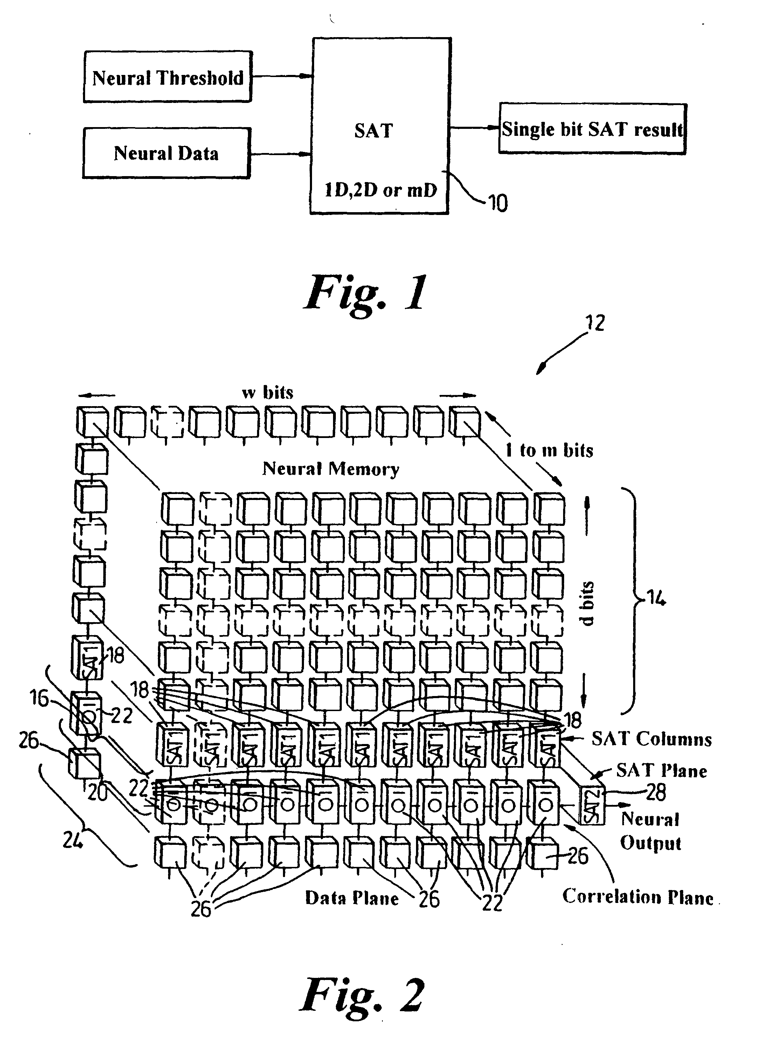

Referring now to Figure 1, neural data and a neural threshold are supplied to a Hamming value comparator 10 of one of the types discussed above, whether of one, two or of greater dimension. The input and threshold tuples are weightless. The output of the comparator 10 indicates whether the neural data has exceeded the neural threshold. The output is then viewed as the single output of the comparator or neuron which is taken to have "fired" if the bit has set. In this sense, the Hamming value comparator 10 acts as a binary neuron.

Figure 2 shows an embodiment of a neural pattern matcher 12 which uses an array of sum and threshold devices, which may be those of the type just described, or any other suitable SAT element. For ease of visualisation, this is illustrated as a 3-dimensional array, comprising a neural memory block 14 of dimensions w x d x m, where 'm' is the number of bits in the digital input word, 'w' is the number of bits in the width of the input pattern and 'd' is the number of exemplars in the neural memory. The arrangement of neural memory is referred to elsewhere herein as neuroram.

The 3-dimensional array further includes a first sum and threshold region 16 (otherwise referred to as SAT columns) made up of (w x m) SAT devices 18 each marked SAT 1 having d inputs (only one of these shown for clarity). Beneath the sum and threshold region 116 there is a correlation plane 20 made up of (w x m) 2 input **EX-NOR** gates 22 each of which receives an input from an associated SAT1 device 14 and an input from an associated data plane 24 which, optionally, may be held in separate bit memories 26. The outputs of the **EX-NOR** gates 22 in the correlation plane 20 are passed horizontally to a second sum and threshold region (referred to as a SAT plane), which consist of a single SAT2 device 28 with w x m inputs.

Respective thresholds T₁ of up to d bits are supplied to the SAT1 devices 18, and a threshold T₂ of up to w x m bits is supplied to the SAT2 device 28.

In use, incoming digital data is encoded using a unit Hamming distance code such as thermometer code, Gray code, or is in the form of a half tone bit map etc. Data for training (or for recognition after learning) is presented in parallel to the input of the data plane 24, or sequentially using a planar shift register (not shown). Optionally, the coded data may also be scrambled with a binary key string using **EX-OR** gates. The neural memory is programmed with 'd' exemplars each of w x m bits which can be prestored, learnt in a separate training routine, or adaptively altered during use.

The thresholds T₁ and T₂ determine the learning rate and quality factor of the neural pattern matcher/neural filter and are set according to fixed values, e.g. 66%. Alternatively the threshold may be adaptively set to determine the irritability (firing rate) of the system. Thresholds T₁ and T₂ may be thought of as a control over the degree of confidence attached to a match.

In considering operation of the device it is helpful to consider the action of one of the SAT1 devices. If the threshold T₁ for that particular device is set at 66% of the number of exemplars (e.g. T₁ is 8 if the neural memory is 12 bits deep), then the SAT1 device will provide a set bit or "fire" if there are more than 8 bits set in the column of neural memory above it. If T₁ is raised, then the SAT1 device will not fire until a greater proportion of the bits in the memory above it are set; in other words the degree of similarity of the bits in that column must be higher for the SAT1 to fire.

The outputs of all the (w x m) SAT1 devices may be considered as a generic template against which new data in the data plane is compared.

The threshold T₂ is an indicator of the degree of confidence insofar as the greater T₂, the greater the number of correlations there have to be between the input data plane and the generic template plane for the pattern to be accepted.

The update of the neural memory can be "supervised" during a training phase in which "d" exemplars or patterns of the required class are presented to the system and the neural memory then frozen. Alternatively, the update of neural memory can be unsupervised, so that the system continuously learns or adapts to incoming patterns after some initial patterns have been fed in. Initially it may be wise to set the neural memory to random values when used in an unsupervised mode of training. To prevent drifting, a portion of the memory may be made "read only".

In this arrangement, the array may be regarded as a pattern matcher, or a category or class correlator. It is analogous in some respects to a cortical column in physiological neural systems, and a group of arrays or neurorams is analogous to a cortical map. A group of neurorams can be ordered linearly or in planes. Planar arrangements can be formed from sub-patterns of neurorams; such as triangles, squares, hexagons, etc. The array provides a hardware embodiment of a neural auto-associative memory.

As a modification of the sum and threshold technique described above, a Sum and Threshold element has been designed that accepts a weightless binary input and a weighted binary threshold. This Sum and Threshold element utilises a thermometer code converter, for example based on the thermometer code converter array described in our International Patent Application No WO99/33184 and the appropriate output or outputs of the array are monitored or processed in accordance with the value of the threshold.

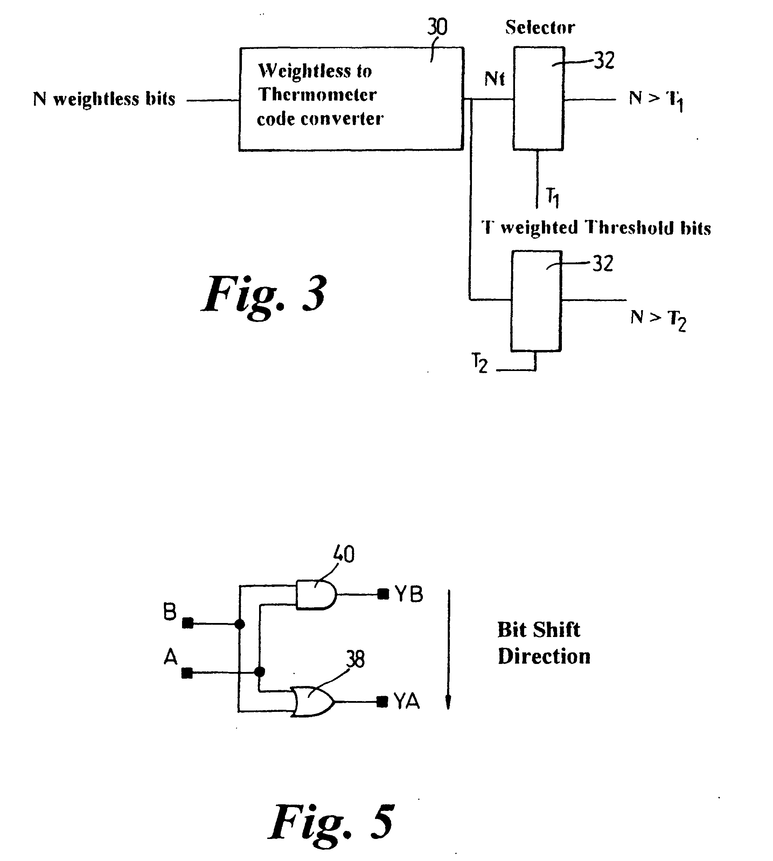

Figure 3 shows a general arrangement of a sum and threshold element with weightless synaptic inputs and a weighted binary threshold. N weightless bits are supplied to a thermometer code converter 30 to obtain thermometer code Nₜ, which is passed to one or more selectors 32, each of which also receives a respective weighted threshold value T₁, T₂, etc. The selector 32 decodes the weighted threshold value and looks at the appropriate bit position in the thermometer code Nₜ, and if set (indicating that the thermometer code has a Hamming value greater than the specified threshold), the selector sets its output bit to indicate that N>T.

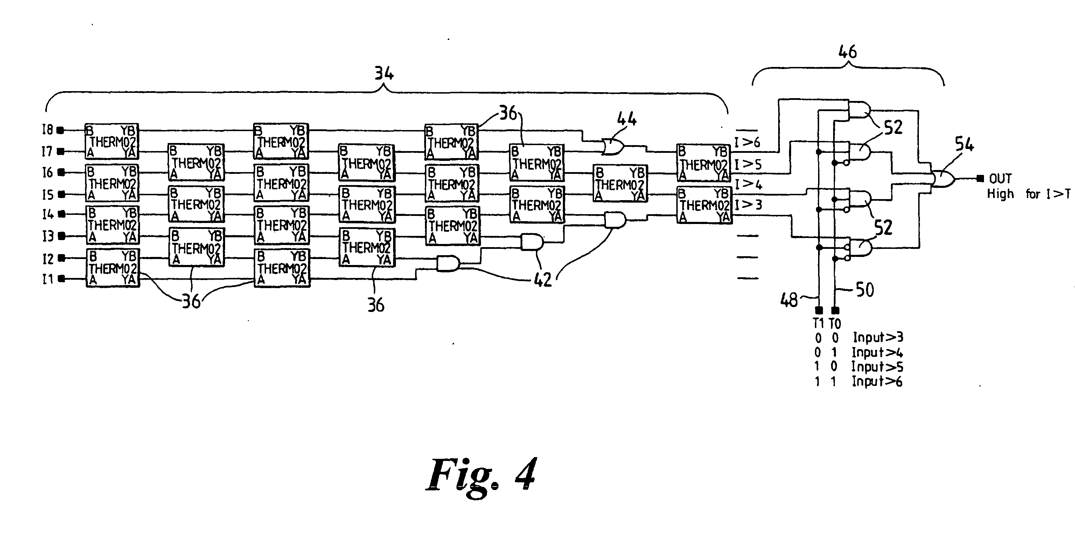

Figure 4 is a circuit diagram of an example of a sum and threshold device having eight synaptic inputs and a choice of four thresholds. The device comprises a thermometer code converter section 34, made up of 2-bit manipulator cells 36 of the type shown in Figure 5. The 2-bit manipulator cells each comprise an OR gate 38 and an AND gate 40, interconnected such that inputs a, b map to outputs Ya,Yb as follows:-$\text{Ya = A OR B}$$\text{Yb = A AND B}$

It should be noted that in the device of Figure 4, there are eight inputs, thus requiring odd layers nominally of four 2-bit manipulator cells 36 wide and even layers nominally of three 2-bit manipulator cells 38 wide, making up eight layers in all, although the fifth to eighth layers have been truncated in this case.

The thresholds in this example are I>6, I>5, I>4 and I>3, meaning that only the fourth to seventh outputs (from the bottom of the array as viewed) are required. Because of the truncation, the fifth to seventh layers include **AND** gates 42 at the lower truncation boundary, and the seventh layer includes an **OR** 44 gate.

The output of the thermometer code conversion section 34 passes to a weighted binary selector 46 which acts as a threshold decoder. Such devices are already known for use as binary multiplexers or logical selectors. In this example, which allows selection of one of four threshold values 3, 4, 5, 6, the selector 40 comprises two weighted inputs 48, 50 which are each connected to the inputs of 3-input **AND** gates 52, the other input of each **AND** gate being a respective output from the thermometer code conversion section 34. Selected terminals of the lower three **AND** gates are inverted, and the outputs of the **AND** gates pass to an **OR** gate 54. Different permutations of 0's and 1's applied to the weighted inputs select different bit positions at the output of the thermometer code conversion section 34.

The selector 46 has the following mapping:-

| Inputs | | Thermometer Code |
|---|---|---|
| T₁ | T₀ | Bit Position |
| 0 | 0 | 4 |
| 0 | 1 | 5 |
| 1 | 0 | 6 |
| 1 | 1 | 7 |

Thus if the weighted input is (1,0) the device will fire only if the Hamming value of the weightless input is greater than 5.

If two or more thresholds are to be determined, then further weighted binary selectors could be connected to the output of the thermometer code converter, as shown in Figure 3.

It will be appreciated also that the circuit could be simplified to respond to a given specific threshold; in this instance a binary selector as such would not be required and instead the output of the thermometer code converter corresponding to T_{fixed}+1, where T_{fixed} is the fixed threshold, would be the output.

The devices described above provide robust hardware implementation which is fault tolerant due to its weightless techniques.

In general, the implementation of the above arrangement is technology independent; electronic, ionic, magnetic or electromagnetic (e.g. optical) implementation are all suitable.

## Claims

1. A device for processing data representing a plurality of exemplars thereby to determine a generic template representing said exemplars, said device comprising:-
an array (14) of bit memory means defining a neural memory for storing binary bits representing a plurality of exemplars, and
an array (16) of sum and threshold devices (18) each for receiving as inputs the bits from respective groups of said bit memory means in said array (14), and each for providing a preset output if the sum of said inputs exceeds a preset threshold, thereby to obtain at the output of said array (16) of sum and threshold devices a bit pattern defining a generic template representing said exemplars.

2. A device according to Claim 1, further operable to determine the extent of matching between a set of input data and said plurality of exemplars, said device comprising means (20,22,28) for comparing or correlating a set of input data (24,26) with said generic template at each of a plurality of bit positions, and providing an output representative of the extent of matching between said set of input data and said generic template.

3. A device according to Claim 1 or Claim 2, wherein said neural memory comprises means (14) for storing a plurality of 2-dimensional data arrays.

4. A device according to Claim 2, or Claim 3 when dependent on Claim 2 including means (26) for presenting said input data in parallel to a data plane (24) for correlation with said generic template.

5. A device according to any of the preceding Claims, wherein the means (20) for correlating comprises an array of logic elements (22).

6. A device according to Claim 2, including further sum and threshold means (28) for receiving the output of said means (20,22,28) for comparing and correlating to compare the sum of said comparison or correlation results with a threshold and to provide an output representative of a match, if said sum exceeds said threshold.

7. A device according to any of the preceding Claims, wherein the, or at least one of the, sum and threshold devices (18,28) comprises a Hamming value comparator made up of a plurality of interconnected bit manipulation cells (26), each bit manipulation cell being operable to effect at least one of a bit shift and a bit elimination operation.

8. A device according to any of the preceding claims wherein at least one of said sum and threshold devices comprises means for converting the input applied thereto into thermometer code and means for monitoring the bit at a bit position corresponding to said threshold, thereby to apply a sum and threshold operation to the bits applied to the input thereof.

9. A method of processing a plurality of exemplars, thereby to determine a generic template representing said exemplars, which comprises:-
(i) providing an array (16) of sum and threshold devices (18) each with an input and an output and operable to provide a preset output if the sum of the bits applied to the input exceeds a preset threshold;
(ii) for each exemplar applying respective bits thereof to the inputs of respective sum and threshold devices (18) according to the bit position,
thereby to obtain a bit pattern defining a generic template representing said exemplars.

10. A method for processing a set of input data and a plurality of exemplars to determine the extent of matching therebetween which comprises:
(i) providing an array (16) of sum and threshold devices (18) each with an input and an output and operable to provide a preset output if the sum of the bits applied to the input exceeds a preset threshold;
(ii) for each exemplar applying respective bits thereof to the inputs of respective sum and threshold devices (18) according to the bit position,
thereby to obtain a bit pattern defining a generic template representing said exemplars, and comparing or correlating said set of input data with said generic template.

## Patentansprüche

1. Vorrichtung zur Verarbeitung von Daten, die eine Mehrzahl von Exemplaren repräsentieren, um dadurch eine allgemeine Schablone zu bestimmen, die diese Exemplare repräsentiert, wobei die Vorrichtung die folgenden Merkmale aufweist:
es ist ein Feld (14) mit Bit-Speichermitteln vorgesehen, die einen Neuronenspeicher definieren, um Binär-Bits zu speichem, die eine Mehrzahl von Exemplaren repräsentieren, und
es ist ein Feld (16) von Summierungs- und Schwellwert-Vorrichtungen (18) vorgesehen, von denen jede als Eingänge die Bits von jeweiligen Gruppen der Bit-Speichermittel in dem Feld (14) empfängt und von denen jede einen eingestellten Ausgang liefert, wenn die Summe der Eingänge einen bestimmten Schwellwert überschreitet, wodurch am Ausgang des Feldes (16) der Summierungs- und Schwellwert-Vorrichtungen ein Bit-Muster erhalten wird, das eine allgemeine Schablone definiert, die die Exemplare repräsentiert.

2. Vorrichtung nach Anspruch 1, welche außerdem das Ausmaß der Anpassung zwischen einer Gruppe von Eingangsdaten und der Mehrzahl der Exemplare bestimmt, wobei die Vorrichtung Mittel (20, 22, 28) aufweist, um eine Gruppe von Eingangsdaten (24, 26) mit der allgemeinen Schablone an jeder der mehreren von Bit-Positionen zu vergleichen und zu korrelieren und einen Ausgang zu schaffen, der repräsentativ ist für das Ausmaß der Anpassung zwischen der Gruppe von Eingangsdaten und der allgemeinen Schablone.

3. Vorrichtung nach Anspruch 1 oder 2, bei welcher der Neuronenspeicher Mittel (14) aufweist, um mehrere zweidimensionale Datenfelder zu speichern.

4. Vorrichtung nach Anspruch 2 oder 3 bei Abhängigkeit von Anspruch 2, welche Mittel (26) aufweist, um die Eingangsdaten parallel zu einer Datenebene (24) zu präsentieren, um die allgemeine Schablone die korrelieren.

5. Vorrichtung nach einem der vorhergehenden Ansprüche, bei welcher die Mittel (20) zur Korrelierung ein Feld logischer Elemente (22) umfassen.

6. Vorrichtung nach Anspruch 2, welche weiter Summierungs- und Schwellwert-Mittel (28) aufweist, um den Ausgang der Mittel (20, 22, 28) zum Vergleich und zur Korrelierung zu empfangen, um die Summe der Vergleichs- und Korrelierungs-Ergebnisse mit einem Schwellwert zu vergleichen und einen Ausgang zu liefern, der repräsentativ ist für eine Anpassung, wenn die Summe den Schwellwert überschreitet.

7. Vorrichtung nach einem der vorhergehenden Ansprüche, bei welcher die Summierungs- und Schwellwert-Vorrichtung (18, 28) oder wenigstens eine davon einen Hammingwert-Komparator aufweist, der aus einer Vielzahl von miteinander verbundenen Bit-Manipulationszellen (26) besteht, wobei jede Bit-Manipulationszelle wenigstens eine Bit-Verschiebung und/oder eine Bit-Eiiminierungsoperation bewirkt.

8. Vorrichtung nach einem der vorhergehenden Ansprüche, bei welcher wenigstens eine der Summierungs- oder Schwellwert-Vorrichtungen Mittel aufweist, um den daran angelegten Eingang in einen Thermometercode umzuwandeln und Mittel vorgesehen sind, um das Bit an einer Bit-Stellung zu überwachen, die dem Schwellwert entspricht, wodurch eine Summierungs- und Schwellwert-Operation auf die dem Eingang hiervon zugeführten Bits ausgeübt wird.

9. Verfahren zur Verarbeitung einer Mehrzahl von Exemplaren, um dadurch eine allgemeine Schablone zu bestimmen, die die Exemplare repräsentiert, wobei das Verfahren die folgenden Schritte umfasst:
(i) es wird ein Feld (16) von Summierungs- und Schwellwert-Vorrichtungen (18) vorgesehen, von denen jede einen Eingang und einen Ausgang besitzt, und es wird ein vorbestimmter Ausgang erzeugt, wenn die Summe der dem Eingang zugeführten Bits einen vorbestimmten Schwellwert überschreitet;
(ii) für jedes Exemplar werden jeweils Bits hiervon den Eingängen der jeweiligen Summierungs- und Schwellwert-Vorrichtung (18) gemäß der Bit-Position angelegt,
wodurch ein Bit-Muster erhalten wird, das eine allgemeine Schablone definiert, welche die Exemplare repräsentiert.

10. Verfahren zur Verarbeitung einer Gruppe von Eingangsdaten und einer Mehrzahl von Exemplaren, um das Ausmaß der Anpassung dazwischen zu bestimmen, wobei das Verfahren die folgenden Schritte umfasst:
(i) es wird ein Feld (16) von Summierungs- und Schwellwert-Vorrichtungen (18) vorgesehen, von denen jedes einen Eingang und einen Ausgang besitzt und einen vorbestimmten Ausgang liefert, wenn die Summe der dem Eingang zugeführten Bits einen vorbestimmten Schwellwert überschreitet;
(ii) für jedes Exemplar werden jeweils Bits hiervon den Eingängen der jeweiligen Summierungs- und Schwellwert-Vorrichtungen (18) gemäß der Bit-Position zugeführt,
wodurch ein Bit-Muster erhalten wird, das eine allgemeine Schablone definiert, die die Exemplare repräsentiert, und es wird die Gruppe von Eingangsdaten mit der allgemeinen Schablone verglichen oder korreliert.

## Revendications

1. Dispositif permettant de traiter des données représentant une pluralité d'exemples, afin de déterminer ainsi un modèle générique représentant lesdits exemples, ledit dispositif comprenant :
une matrice (14) de moyens de mémoire de bits définissant une mémoire neuronale permettant de stocker des bits sous forme de valeurs binaires représentant une pluralité d'exemples, et
une matrice (16) de dispositifs de somme et de seuil (18), chacun recevant comme entrées les bits provenant des groupes respectifs desdits moyens de mémoire de bits de ladite matrice (14), et chacun délivrant une sortie prédéfinie si la somme desdites entrées dépasse un seuil prédéfini, afin d'obtenir ainsi au niveau de la sortie de ladite matrice (16) de dispositifs de somme et de seuil un schéma de bits définissant un modèle générique représentant lesdits exemples.

2. Dispositif selon la revendication 1, permettant en outre de déterminer l'étendue de concordance entre une série de données entrées et ladite pluralité d'exemples, ledit dispositif comprenant des moyens (20, 22, 28) permettant de comparer ou de mettre en corrélation une série de données entrées (24, 26) avec ledit modèle générique pour chacune d'une pluralité de positions binaires, et permettant de fournir une sortie représentative de l'étendue de concordance entre ladite série de données entrées et ledit modèle générique.

3. Dispositif selon la revendication 1 ou la revendication 2, dans lequel ladite mémoire neuronale comprend des moyens (14) pour stocker une pluralité de matrices de données bidimensionnelles.

4. Dispositif selon la revendication 2, ou selon la revendication 3 quand elle dépend de la revendication 2, comprenant des moyens (26) permettant de présenter lesdites données entrées parallèlement à un plan de données (24) pour établir une corrélation avec ledit modèle générique.

5. Dispositif selon l'une quelconque des revendications précédentes, dans lequel les moyens (20) pour établir une corrélation comprennent une matrice d'éléments logiques (22).

6. Dispositif selon la revendication 2, comprenant en outre des moyens de somme et de seuil (28) pour recevoir la sortie desdits moyens (20, 22, 28) permettant de comparer et de mettre en corrélation afin de comparer la somme desdits résultats de la comparaison ou de la mise en corrélation avec un seuil, et de fournir une sortie représentative d'une concordance, si ladite somme dépasse ledit seuil.

7. Dispositif selon l'une quelconque des revendications précédentes, dans lequel au moins l'un des dispositifs de somme et de seuil (18, 28) comprend un comparateur de valeurs de Hamming composé d'une pluralité de cellules de manipulation de bits connectées entre elles (26), chaque cellule de manipulation de bits pouvant fonctionner pour effectuer au moins l'une des opérations de décalage de bits et de suppression de bits.

8. Dispositif selon l'une quelconque des revendications précédentes dans lequel au moins un desdits dispositifs de somme et de seuil comprend des moyens permettant de convertir l'entrée appliquée à celui-ci en un code de thermomètre, et des moyens permettant de contrôler le bit au niveau d'une position binaire correspondant au dit seuil, afin d'effectuer ainsi une opération de somme et de seuil sur les bits appliqués à l'entrée de celui-ci.

9. Procédé permettant de traiter une pluralité d'exemples, et de déterminer ainsi un modèle générique représentant lesdits exemples, comprenant les étapes consistant à :
(i) fournir une matrice (16) de dispositifs de somme et de seuil (18) possédant chacun une entrée et une sortie, et fonctionnant pour délivrer une sortie prédéfinie si la somme des bits appliqués à l'entrée dépasse un seuil prédéfini ;
(ii) appliquer pour chaque exemple les bits respectifs de ceux-ci aux entrées des dispositifs de somme et de seuil respectifs (18) en fonction de la position binaire,
afin d'obtenir ainsi un schéma de bits définissant un modèle générique qui représente lesdits exemples.

10. Procédé permettant de traiter une série de données entrées et une pluralité d'exemples afin de déterminer l'étendue des concordances entre ceux-ci, comprenant les étapes consistant à :
(i) fournir une matrice (16) de dispositifs de somme et de seuil (18) possédant chacun une entrée et une sortie et fonctionnant pour délivrer une sortie prédéfinie si la somme des bits appliqués à l'entrée dépasse un seuil prédéfini,
(ii) appliquer pour chaque exemple les bits respectifs de ceux-ci aux entrées des dispositifs de somme et de seuil respectifs (18) en fonction de la position binaire,
afin d'obtenir ainsi un schéma de bits définissant un modèle générique qui représente lesdits exemples, et de comparer ou de mettre en corrélation ladite série de données entrées avec ledit modèle générique.
